**Europäisches Patentamt**

**European Patent Office**

**Office européen des brevets**

(19)

(11) Numéro de publication: **0 046 103**
**B1**

(12) **FASCICULE DE BREVET EUROPEEN**

(45) Date de publication du fascicule du brevet:
18.04.84

(51) Int. Cl.³: **H 03 D 3/00, H 04 N 9/40**

(21) Numéro de dépôt: **81401207.6**

(22) Date de dépôt: **28.07.81**

(54) **Procédé de démodulation d'un signal modulé en fréquence, et démodulateur mettant en oeuvre ce procédé.**

(30) Priorité: **13.08.80 FR 8017840**

(43) Date de publication de la demande:
**17.02.82 Bulletin 82/7**

(45) Mention de la délivrance du brevet:
**18.04.84 Bulletin 84/16**

(84) Etats contractants désignés:
**AT CH DE GB IT LI LU NL SE**

(56) Documents cités:
**EP - A - 0 029 376**
**FR - A - 2 433 756**
**US - A - 3 956 623**
**US - A - 4 090 145**

**ELECTRONICS LETTERS, vol. 15, no. 16, 2 août 1979**
**Londres, GB COUPE: "Digital frequency discriminator",**
**pages 489-490**

(73) Titulaire: **THOMSON-CSF, 173, Boulevard Haussmann,**
**F-75379 Paris Cedex 08 (FR)**

(72) Inventeur: **Moraillon, Jean-Yves,**
**THOMSON-CSF-SCPI 173, bld Haussmann,**
**F-75360 Paris Cedex 08 (FR)**

(74) Mandataire: **Turlèque, Clotilde et al, THOMSON-CSF**
**SCPI 173, Bld Haussmann, F-75379 Paris Cedex 08 (FR)**

## Procédé de démodulation d'un signal modulé en fréquence et démodulateur mettant en œuvre ce procédé

La présente invention concerne les procédés de démodulation d'un signal modulé en fréquence, et les démodulateurs mettant en œuvre ces procédés, en particulier ceux utilisés dans les systèmes de télévision SECAM.

Dans le système SECAM les informations de couleur modulent en fréquence une sous-porteuse située au voisinage de l'extrémité des fréquences les plus élevées et à l'intérieur du spectre de luminance. Ce dernier s'étend de 0 à 6 MHz environ et la sous-porteuse, dont l'excursion de fréquence s'étend entre 3,9 et 4,7 MHz est mélangée au spectre principal. Divers systèmes ont été imaginés pour démoduler cette sous-porteuse à l'aide de discriminateurs de fréquence classiques qui présentent l'inconvénient d'être sensibles aux variations d'amplitude du signal à traiter.

D'autre part le brevet US-A-4 090 145 décrit un démodulateur comportant deux changeurs de fréquence recevant le signal à démoduler d'une part, et d'autre part recevant respectivement deux signaux de meme fréquence mais en quadrature. Les signaux fournis par les deux changeurs de fréquence sont déphasés de $\frac{\pi}{2}$. Ils sont échantillonnés et numérisés, puis un dispositif de calcul détermine une valeur de la phase du signal modulé en calculant l'arctangente du rapport des amplitudes de ces deux signaux à un même instant. La valeur de la fréquence est déduite de la valeur de variation de la phase. Ce dispositif a pour inconvénient de fournir une valeur imprécise du signal de modulation car le déphasage $\frac{\pi}{2}$ réalisé par ce dispositif n'est pas rigoureusement constant lorsque la fréquence varie sous l'action de la modulation.

Il a été décrit dans la demande de brevet EP-A-0 029 376 publié le 27.5.81, un procédé permettant d'effectuer par un procédé numérique une démodulation d'un signal modulé en fréquence, en particulier d'un signal de chrominance d'un signal vidéo SECAM, tout en présentant l'avantage de ne pas être sensible aux variations d'amplitude du signal à fréquence faible par rapport à la fréquence centrale. Ce document appartient à l'état de la technique visé à l'article 54, paragraphe 3 de la CBE.

Ce procédé de démodulation consiste, en considérant le signal à démoduler comme étant la projection sur un axe Ox d'un vecteur tournant Z(t) autour d'un point O dans un repère Oxy, à déterminer les variations de la fréquence du signal à démoduler d'après les variations de la vitesse de rotation du vecteur tournant, cette détermination s'effectuant à partir du calcul d'un rapport de combinaisons linéaires d'échantillons de la valeur de la projection sur l'axe Ox du vecteur tournant. En particulier, l'un des exemples de procédé décrit dans la demande de brevet EP-A-0 029 376 consiste à échantillonner le signal de chrominance d'un signal vidéo SECAM à un rithme égal à 4 fois la fréquence centrale F de la bande de fréquence du signal, puis à déterminer la position du vecteur tournant au moyen de deux échantillons successifs du signal, et à déterminer une première valeur de la variation de fréquence entre deux instants distants de $\frac{1}{F}$ par comparaison de la position du vecteur tournant à ces instants. Les formules suivantes sont établies:

$$① \hat{\Theta}(t) = \text{arc tg} \frac{y(t)}{x(t)} \quad \text{avec tg } \hat{\Theta}(t) = \frac{\sin\left[\Theta(t) - \frac{\pi}{2}\frac{\delta F}{F}\right]}{\cos \Theta(t)}$$

$$② \Delta\hat{\Theta}(t') = \hat{\Theta}(t + \frac{1}{F}) - \hat{\Theta}(t) \quad \text{avec } t' = t + \frac{1}{F}$$

$$③ \Delta\hat{\Theta}(t') = 2\pi \frac{\hat{\Delta} F}{F}$$

$\delta F$ étant la valeur de l'excursion de fréquence.

$\Theta(t)$ étant l'angle du vecteur Z(t) avec l'axe Ox du repère Oxy; cet angle permet de repérer la position du vecteur Z(t).

x(t) étant la projection du vecteur Z(t) sur l'axe Ox; x(t) correspond donc au signal à démoduler.

y(t) étant la projection sur l'axe Ox du vecteur «en quadrature» par rapport à Z(t); y(t) correspond donc à la projection sur l'axe Oy du vecteur Z(t).

$\hat{\Theta}(t)$ étant une estimation de l'angle $\Theta(t)$.

$\hat{\Delta}\Theta(t')$ étant une estimation de l'écart d'angle entre deux positions du vecteur Z(t) à des instants espacés de $\frac{1}{F}$ et $\hat{\Delta}F$ étant la valeur de la variation de fréquence entre deux instants espacés de $\frac{1}{F}$.

La bande relative du signal de chrominance étant petite devant F = 4,3 MHz, il a été considéré dans le calcul des formules ①, ② et ③ que la valeur $\frac{\delta F}{F}$ est très inférieure à 1.

L'erreur commise sur $\hat{\Delta}F$ due à cette approximation $\frac{\delta F}{F} << 1$ dépend de la position du vecteur et de la fréquence à démoduler.

En effet, d'aprés la formule ①:

$$⑩ \hat{\Theta}(t) = \text{arc tg} \frac{\sin\left[\Theta(t) - \frac{\pi}{2}\cdot\frac{\delta F}{F}\right]}{\cos \Theta(t)}$$

$$= \text{arc tg} \left[\cos\frac{\pi}{2} \cdot \frac{\delta F}{F}\right] \left[\text{tg}\,\hat{\Theta}\,(t) - \text{tg}\,(\frac{\pi}{2} \cdot \frac{\delta F}{F})\right]$$

il peut etre démontré que l'erreur commise sur l'angle $\hat{\Theta}(t)$ par l'application de la formule ⑩ est de la forme:

$$\delta\hat{\Theta}\,(t) = \frac{\varepsilon^2}{4} \sin 2\,\Theta\,(t) + \frac{\varepsilon}{2}[1 + \cos 2\,\Theta\,(t)]$$

avec $\varepsilon = \frac{\pi}{2} \frac{\delta F}{F}$.

Le premier terme $\frac{\varepsilon^2}{4} \sin 2\,\Theta\,(t)$ dû à la présence du facteur $\cos(\frac{\pi}{2} \cdot \frac{\delta F}{F})$ dans l'expression de $\hat{\Theta}\,(t)$ (formule ⑩ est négligeable devant le terme $\frac{\varepsilon}{2}[1 + \cos 2\,\Theta\,(t)]$ dû à la présence du terme $\text{tg}\,(\frac{\pi}{2} \frac{\delta F}{F})$.

Il peut en outre être démonstré que l'erreur résultante commise sur $\hat{\Delta}\,F$ après un calcul de la forme $\hat{\Delta}\,F = \frac{F}{2\pi}\,[\hat{\Theta}\,(t') - \hat{\Theta}\,(t)]$ (formules ② et ③ est fonction de l'angle $\Theta\,(t)$ par un terme de la forme $\sin 2\,\Theta\,(t)$. L'erreur change donc de signe pour des angles en quadrature. C'est la raison pour laquelle il est envisagé dans la demande de brevet EP-A-0 029 376 une première méthode de minimisation d'erreur consistant à prendre la moyenne arithmétique de deux valeurs de $\hat{\Delta}\,F$ obtenues à partir de deux positions du vecteur Z(t), approximativement en quadrature.

L'erreur relative $\frac{\delta\,(^2\hat{\Delta}\,F)}{^2\hat{\Delta}\,F}$ de la valeur améliorée $^2\hat{\Delta}\,F$ qui en résulte est modulée en amplitude, par une fonction sinusoïdale de l'angle du vecteur à partir duquel a été calculé $\hat{\Delta}\,F$, autour de la valeur $\varepsilon^2$. Ainsi, l'erreur relative $\frac{\delta\,(^2\hat{\Delta}\,F)}{^2\hat{\Delta}\,F}$ est de l'ordre de $\varepsilon^2$ avec $\frac{(^2\hat{\Delta}\,F)}{^2\hat{\Delta}\,F} \leqslant \varepsilon^2$.

En complément à la première méthode de minimisation d'erreur, il a aussi été envisagé dans la demande de brevet EP-A-0 029 376 une deuxième méthode pour améliorer la valeur $^2\hat{\Delta}\,F$. Cette méthode supplémentaire de minimisation d'erreur consiste à calculer la valeur d'un facteur de correction $\varepsilon_n$ en fonction de $\hat{\Delta}\,F$ et de $\hat{\Theta}(t)$ et à en déduire une valeur finale $^3\hat{\Delta}\,F = (1 - \varepsilon_n) \cdot {}^2\hat{\Delta}\,F$ de la variation de fréquence.

Le procédé de la présente invention a l'intérêt de remplacer la moyenne effectuée, selon la première méthode de minimisation d'erreur, sur les valeurs approchées $\hat{\Delta}\,F$ de l'excursion de fréquence après calcul de la valeur d'arc tangente (Formule ①), par une moyenne effectuée avant le calcul de la valeur d'arc tangente, directement sur les valeurs des échantillons du signal à démoduler. Ceci permet de multiplier par quatre le temps disponible pour calculer les valeurs $\hat{\Theta}\,(t)$, et donc de rendre la réalisation pratique du système beaucoup plus aisée.

La fréquence d'obtention des valeurs calculées $\hat{\Delta}\,F$ sera alors F = 4,3 MHz, valeur encore nettement supérieure à la limite théorique imposée par le théorème de Shannon, la bande passante des signaux de chrominance SECAM, étant de 3,9 à 4,7 MHz.

De plus, l'erreur relative de l'excursion de fréquence, obtenue par le procédé de la présente invention, est quatre fois inférieure à celle de l'excursion de fréquence $^2\hat{\Delta}\,F$ obtenue par le procédé décrit dans la demande de brevet EP-A-0 029 376.

Selon l'invention, il est proposé un procédé de démodulation d'un signal modulé en fréquence autour d'une fréquence centrale F, avec une largeur de bande égale à B telle que $\frac{B}{2F} < 1$, où une valeur approchée $\hat{\Delta}\,F$ d'une variation de la fréquence du signal est calculée en déterminant la vitesse de variation de l'angle $\Theta\,(t)$ repérant la position d'un vecteur tournant associé au signal, où le signal est échantillonné à une fréquence 4F' (F' étant une fréquence de la bande de fréquence du signal), où une valeur approchée $\hat{\Theta}\,'(t)$, de la valeur d'angle $\Theta\,(t)$ repérant le vecteur tournant, est déterminée en calculant la valeur de l'arc tangente du rapport $R = \frac{y'(t)}{x'(t)}$, d'une valeur $x'(t)$ d'un échantillon du signal, pris à l'instant t, est d'une valeur $y'(t)$ moyenne arithmétique des valeurs $x'(t + \frac{1}{4F'})$ est $x'(t - \frac{1}{4F'})$ correspondant respectivement à l'échantillon de signal précédent $x'(t)$ et à l'échantillon suivant $x'(t)$; et où la valeur approchée $\hat{\Delta}\,F$ de la variation de fréquence entre deux instants d'échantillonnage $t_1$, $t_2$, séparés d'une durée de $\frac{1}{F'}$, est déterminée en calculant

$$\hat{\Delta}\,F = \frac{F'}{2\pi}\,\left[\hat{\Theta}\,'(t_2) - \hat{\Theta}\,'(t_1)\right].$$

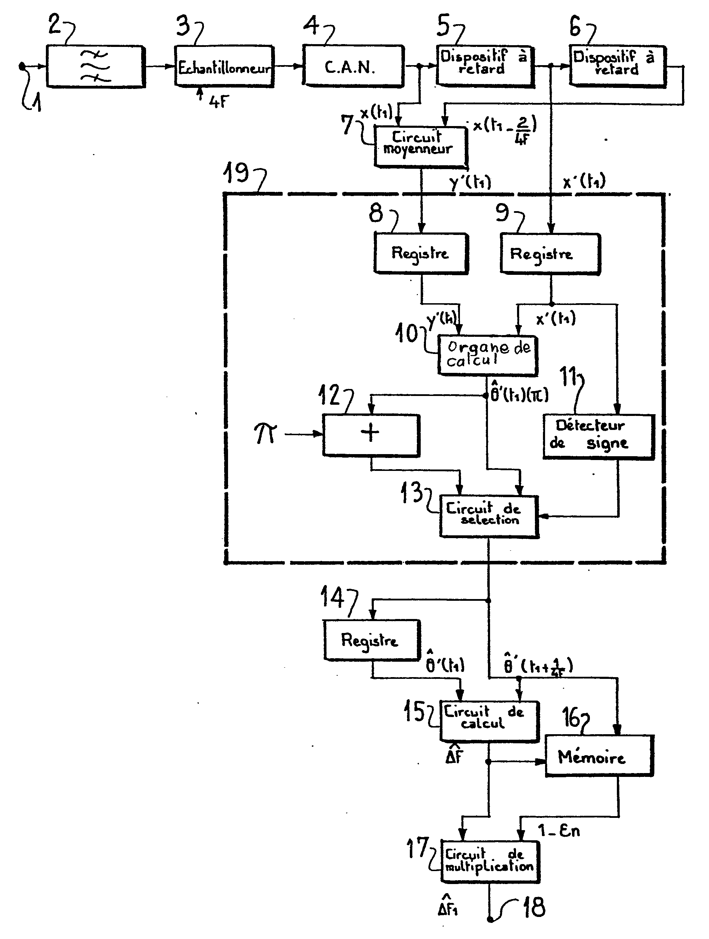

La présente invention sera mieux comprise et d'autres caractéristiques apparaîtront à l'aide d'un calcul dont les principales étapes vont être données ci-après et à l'aide de la description qui suit et de la figure unique s'y rapportant, sur laquelle est représenté un mode de réalisation d'un démodulateur mettant en œuvre ce procédé de calcul.

Comme dans la demande de brevet EP-A-0 029 376 le signal modulé en fréquence est représenté par la projection x(t) sur l'axe Ox d'un re père Oxy d'un vecteur tournant Z(t).

L'expression de x(t) est la suivante:

$$x(t) = \cos\,[2\pi(F + \delta F)t + \psi_o] = \cos\,\Theta\,(t)$$

Les expressions des signaux retardés de $\frac{1}{4F}$ et de $\frac{2}{4F}$ sont les suivantes:

$$x(t-\frac{1}{4F}) = \cos\left[2\pi(F+\delta F)t-\frac{\pi}{2}-\frac{\pi}{2}\cdot\frac{\delta F}{F}\right] = \sin\left[\Theta(t)-\frac{\pi}{2}\cdot\frac{\delta F}{F}\right]$$

$$x(t-\frac{2}{4F}) = -\cos\left[\Theta(t)-\pi\cdot\frac{\delta F}{F}\right]$$

Soit $\Theta'(t) = \Theta(t)-\frac{\pi}{2}\cdot\frac{\delta F}{F}$, ce qui entraîne:

$$x(t) = \cos\left[\Theta'(t)+\frac{\pi}{2}\cdot\frac{\delta F}{F}\right]$$

$$x(t-\frac{1}{4F}) = \sin\Theta'(t) = x'(t)$$

$$x(t-\frac{2}{4F}) = -\cos\left[\Theta'(t)-\frac{\pi}{2}\cdot\frac{\delta F}{F}\right]$$

La moyenne $y'(t)$ entre $x(t)$ et $x(t-\frac{2}{4F})$ a pour expression:

$$y'(t) = \frac{x(t)-x(t-\frac{2}{4F})}{2} = \cos\Theta'(t)-\cos\frac{\pi}{2}\cdot\frac{\delta F}{F}.$$

En considérant, comme dans la demande de brevet EP nº 80.401 542.8, que $\frac{\delta F}{F} << 1$, il peut être calculé une estimation $\hat{\Theta}'(t)$ de l'angle $\Theta(t)$ en appliquant la formule ①, d'où:

$$⑪ \quad \hat{\Theta}'(t) = \arctan\frac{y'(t)}{x'(t)} = \arctan\left[\frac{1}{\cos(\frac{\pi}{2}\cdot\frac{\delta F}{F})}\cdot\tan\Theta'(t)\right]$$

La valeur de l'excursion de fréquence $\hat{\Delta}F$ découle des formules ② et ③ en remplaçant $\hat{\Theta}(t)$ par $\hat{\Theta}'(t)$, d'où:

$$⑫ \quad \hat{\Delta}F = \frac{F}{2\pi}\left[\hat{\Theta}'(t+\frac{1}{F})-\hat{\Theta}'(t)\right]$$

En comparant la formule ⑪ avec la formule ⑩, il peut être constaté que le terme $\tan(\frac{\pi}{2}\cdot\frac{\pi F}{F})$ a disparu. Il en résulte que l'erreur commise sur l'angle $\Theta'(t)$ par le procédé de calcul selon l'invention est $\delta\Theta'(t) = \frac{\varepsilon^2}{4}\sin 2\Theta$ avec $\varepsilon = \frac{\pi}{2}\cdot\frac{\delta F}{F}$, et que l'erreur relative résultante sur un calcul d'excursion de fréquence $\hat{\Delta}F$ par la formule ⑫ est

$$\frac{\delta[\hat{\Delta}F]}{\hat{\Delta}F} = \frac{\varepsilon^2}{2}\cos(2\Theta+4\varepsilon) \quad ⑬$$

Cette erreur est donc deux fois inférieure à celle du procédé décrit précédemment.

La précision peut être encore améliorée en considérant une méthode de minimisation d'erreur semblable à la deuxième méthode de la demande de brevet EP-A-0 029 376 qui consiste à calculer la valeur d'un facteur de correction $\varepsilon_n$ en fonction de $\hat{\Delta}F$ et de $\hat{\Theta}(t)$ et d'en déduire une valeur finale améliorée $\hat{\Delta}F_1 = (1-\varepsilon_n)\cdot\hat{\Delta}F$.

Dans la description relative à la figure unique les dispositifs de synchronisation précise, relevant de la technologie courante, n'ont pas été représentés en vue de rendre le dessin plus clair et de simplifier l'exposé.

Comme il ressort de la figure unique le signal vidéo SECAM à démoduler est reçu sur une borne d'entrée 1 puis est filtré par un filtre passe-bande 2 pour sélectionner uniquement le signal de chrominance. Ce filtre est un filtre passe-bande 3,9 MHz–4,7 MHz, ce qui correspond au spectre de fréquence du signal de chrominance. Ce signal de chrominance est ensuite échantillonné par un échantillonneur 3 suivant une fréquence d'échantillonnage 4F, et converti en signaux binaires par un convertisseur analogique-numérique 4.

Un premier dispositif à retard 5 retarde les échantillons délivrés par le convertisseur analogique-numérique 4 d'une durée $\frac{1}{4F}$. La sortie de ce premier dispositif à retard est couplée à l'entrée d'un deuxième dispositif à retard 6, de retard $\frac{1}{4F}$, qui délivre les échantillons fournis par la sortie du convertisseur analogique-numérique 4 avec un retard $\frac{2}{4F}$.

A un instant d'échantillonnage $t_1$, les deux entrées d'un circuit moyenneur 7 reçoivent respectivement la valeur numérique d'un échantillon $x(t_1)$ délivrée par le convertisseur 4 et la valeur numérique d'un échantillon $x(t_1-\frac{2}{4F})$ délivrée par le deuxième dispositif à retard 6. Le circuit moyenneur 7 permet de calculer la moyenne

$$y'(t_1) = \frac{x(t_1)-x(t_1-\frac{2}{4F})}{2}$$

La sortie du circuit moyenneur 7 et la sortie du premier dispositif à retard 5 sont respectivement connectées à l'entrée d'un premier registre 8 et à l'entrée d'un deuxième registre 9. Ces deux registres 8 et 9, actionnés à la fréquence F, permettent de disposer simultanément de $y'(t_1)$ et de $x'(t_1)$ et de les mémoriser pendant une période $\frac{1}{F}$ pour effectuer les calculs suivants.

Un organe de calcul 10 comportant deux entrées respectivement couplées à la sortie du registre 8 et à la sortie du registre 9, permet de calculer $=\hat{\Theta}'(t_1)$ d'après la formule ⑪ (à $\pi$ près).

Un additionneur 12 dont une entrée est reliée à la sortie de l'organe de calcul 10 fournit $\hat{\Theta}'(t_1) + \pi$, c'est-à-dire $\arctan\frac{y'(t_1)}{x'(t_1)} + \pi$, à la première en-

trée d'un circuit de sélection 13 dont la deuxième entrée est connectée à la sortie de l'organe de calcul 10. Ce circuit de sélection délivre sur la sortie soit la valeur $\hat{\Theta}'(t)$ fournie par l'organe de calcul 10, soit $\hat{\Theta}'(t)+\pi$ fournie par l'additionneur 12. Cette sélection s'effectue en fonction du signe de $y'(t_1)$ et permet de reconstituer la véritable valeur d'angle $\hat{\Theta}'(t_1)$ qui n'est connu qu'à $\pi$ près à la sortie de l'organe de calcul 10. La détection du signe de $y'(t_1)$ est faite par un détecteur de signe 11 dont l'entrée est reliée à la sortie du registre 9.

L'ensemble d'éléments constitué par les deux registres 8 et 9, l'organe de calcul 10, le détecteur de signe 11, l'additionneur 12, et le circuit de sélection 13 forment donc un dispositif de calcul 19 de la valeur d'angle $\hat{\Theta}(t)$ associée à la position du vecteur tournant, dont la sortie est la sortie du circuit de sélection 13. Cette sortie est reliée à l'entrée d'un troisième registre 14, qui permet de mémoriser la valeur d'angle $\hat{\Theta}'(t_1)$ pendant une période $\frac{1}{F}$, afin de pouvoir calculer, à l'apparition d'une nouvelle valeur $\hat{\Theta}'(t_1 + \frac{1}{F})$, l'excursion de fréquence:

$$\Delta F = \frac{F}{2\pi} [\hat{\Theta}'(t_1 + \frac{1}{F}) - \Theta'(t_1)] \quad \text{(formule ⑫)} \text{ à}$$

l'aide d'un circuit de calcul 15 dont les première et deuxième entrées sont respectivement couplées à la sortie du registre 14 et à la sortie du circuit de sélection 13. Cette dernière sortie est également reliée à la première entrée d'adressage d'une mémoire 16 dont l'autre entrée d'adressage est reliée à la sortie du circuit de calcul 15 et qui fournit la valeur du facteur de correction $1-\varepsilon_n$ calculée par la formule ⑬, en fonction de la valeur $\hat{\Theta}'(t)$ fournie par le circuit de sélection 13 et de la valeur $\hat{\Delta} F$ fournie par le circuit de calcul 15. Un circuit de multiplication 17 dont les première et deuxième entrées sont respectivement couplées à la sortie de la mémoire 16 et à la sortie du circuit de calcul 15, délivre sur une borne de sortie 18 la valeur finale de l'excursion de fréquence $\hat{\Delta} F_1 = (1 - \varepsilon_n) \hat{\Delta} F$.

L'invention n'est pas limitée au mode de réalisation décrit et représenté, de nombreuses variantes de réalisation sont possibles.

En particulier, les fonctions effectuées par les dispositifs à retard 5 et 6, le circuit moyenneur 7 et le circuit de calcul 15, les registres 8, 9 et 14, l'additionneur 12, le détecteur de signe 11, le circuit de sélection 13, le circuit de multiplication 17, la mémoire 16 et l'organe de calcul 10 peuvent être réalisés à l'aide de dispositifs à transfert de charge (appelés D.T.C.), le convertisseur analogique-numérique 4 étant alors supprimé.

Dans le mode de réalisation décrit il a été choisi d'échantillonner le signal de chrominance à un rythme égal à 4 fois la fréquence F égale à 4,3 MHz. Mais cette valeur n'est pas restrictive, toute valeur de fréquence F' comprise dans la bande de fréquence du signal de chrominance convient.

En outre, il est possible d'effectuer une dernière opération sur les valeurs numériques $\hat{\Delta} F_1$ obtenue.; à la sortie du circuit de multiplication 17 afin d'obtenir les valeurs qui ne soient pas sensibles aux variations de la fréquence F. Pour cela il suffit, comme décrit dans la demande de brevet EP-A-0 029 376 de sélectionner et de mémoriser les valeurs $\hat{\Delta} f_0$ associées à la salve de référence accompagnant les signaux de synchronisation, et de corriger les valeurs $\hat{\Delta} F_1$ en fonction de ces valeurs.

Enfin, il est à noter que l'invention est applicable à la démodulation de tout signal modulé en fréquence, pourvu que la bande de fréquence du signal soit petite par rapport à la fréquence centrale.

**Revendications**

1. Procédé de démodulation d'un signal modulé en fréquence autour d'une fréquence centrale F, avec une largeur de bande égale à B telle que $\frac{B}{2F} < 1$, où une valeur approchée $\hat{\Delta} F$ d'une variation de la fréquence du signal est calculée déterminant la vitesse de variation de l'angle $\hat{\Theta}(t)$ repérant la position d'un vecteur tournant associé au signal, où le signal est échantillonné à une fréquence 4F' (F' étant une fréquence de la bande de fréquence du signal), où une valeur approchée $\hat{\Theta}'(t)$, de la valeur d'angle $\hat{\Theta}(t)$ repérant le vecteur tournant, est déterminée en calculant la valeur de l'arc tangente du rapport $R = \frac{y'(t)}{x'(t)}$, d'une valeur $x'(t)$ d'un échantillon du signal, pris à l'instant t, et d'une valeur $y'(t)$ moyenne arithmétique des valeurs $x'(t + \frac{1}{4F'})$ et $x'(t - \frac{1}{4F'})$ correspondant respectivement à l'échantillon de signal précédant $x'(t)$ et à l'échantillon suivant $x'(t)$; et où la valeur approchée $\hat{\Delta} F$ de la variation de fréquence entre deux instants d'échantillonnage $t_1$, $t_2$, séparés d'une durée de $\frac{1}{F'}$, est déterminée en calculant

$$\hat{\Delta} F = \frac{F'}{2\pi} [\hat{\Theta}'(t_2) - \hat{\Theta}'(t_1)].$$

2. Procédé selon la revendication 1, caractérisé en ce que l'erreur $\delta(\hat{\Delta} F)$ commise en déterminant la valeur approchée $\hat{\Delta} F$ de la variation de fréquence, est corrigée en multipliant cette valeur approchée $\hat{\Delta} F$ par un facteur de correction $1-\varepsilon_n)$ tel que $\varepsilon_n \cong \frac{\delta(\hat{\Delta} F)}{\hat{\Delta} F} \cong \frac{\varepsilon^2}{2} \times \cos(2 \hat{\Theta}' + 4 \varepsilon)$ avec $\varepsilon = \frac{\delta F}{F}$ et où $\delta F$ est l'excursion de fréquence autour de la fréquence centrale F.

3. Démodulateur d'un signal modulé en fréquence, mettant en œuvre le procédé de la revendication 1, caractérisé en ce qu'il comporte un échantillonneur (4) échantillonnant le signal modulé à une fréquence 4F', et ayant une sortie; un convertisseur analogique-numérique (4) ayant une entrée couplée à la sortie de l'échantillonneur (3), et une sortie; un premier dispositif à retard (5) de retard égal à $\frac{1}{4F'}$ ayant une entrée couplée à la sortie du convertisseur (4) et une sortie délivrant le signal x'(t) à l'instant t; un deuxième dispositif à retard (6) de retard égal à $\frac{1}{4F'}$, ayant une entrée couplée à la sortie du premier dispositif à retard (5) et une sortie; un circuit moyenneur (7), faisant la moyenne arithmétique de ses signaux d'entrée, ayant une première et une deuxième entrées respectivement couplées à la sortie du convertisseur (4) et à la sortie du deuxième dispositif à retard (6), et une sortie délivrant le signal y'(t); un dispositif de calcul (19) déterminant, selon la formule:

$$⑪ \hat{\Theta}'(t) = \text{arc tg}\frac{y'(t)}{x'(t)},$$ la valeur approchée $\hat{\Theta}'(t)$ de la valeur d'angle $\hat{\Theta}(t)$ associée à la position du vecteur tournant, ayant une première et une deuxième entrées respectivement couplées à la sortie du circuit moyenneur (7) et à la sortie du premier dispositif à retard (5), et une sortie; un registre (14) pour mémoriser chaque valeur d'angle $\Theta'(t)$ pendant une période $\frac{1}{F'}$ et ayant une entrée couplée à la sortie du dispositif de calcul (19) et une sortie; un circuit de calcul (15) ayant une première et une deuxième entrées respectivement couplées à la sortie du dispositif de calcul (19) et à la sortie du registre (14), et une sortie délivrant la valeur approchée $\hat{\Delta}F$ de la variation de fréquence, selon la formule ⑫:

$$\hat{\Delta}F = \frac{F'}{2\pi}\left[\hat{\Theta}'(t+\frac{1}{F'}) - \hat{\Theta}'(t)\right]$$

4. Démodulateur selon la revendication 3 mettant en œuvre le procédé selon la revendication 2, caractérisé en ce qu'il comporte une mémoire (16), ayant une première et une deuxième entrées d'adressage respectivement couplées à la sortie du dispositif de calcul (19) et à la sortie du circuit de calcul (15), stockant en permanence et délivrant les valeurs du facteur de correction $(1-\varepsilon_n)$; un circuit de multiplication (17) ayant une première entrée couplée à la sortie du circuit de calcul (15), une deuxième entrée couplée à la sortie de la mémoire (16) et une sortie délivrant la valeur approchée corrigée $\hat{\Delta}F_1 = (1-\varepsilon_n)\,\hat{\Delta}\cdot F$ de la variation de fréquence.

5. Démodulateur selon la revendication 3, caractérisé en ce que les dispositifs couplés à la sortie de l'échantillonneur (3) sont des dispositifs à transfert de charge (D.T.C), et en ce que le convertisseur analogique-numérique est supprimé.

## Patentansprüche

1. Verfahren zur Demodulation eines Signals, das um eine Mittenfrequenz F frequenzmoduliert ist mit einer solchen Bandbreite B, dass $B/2F < 1$, worin ein angenäherter Wert $\hat{\Delta}F$ einer Frequenzvariation des Signals berechnet wird, indem die Änderungsgeschwindigkeit des Winkels $\hat{\Theta}(t)$ berechnet wird, durch den die Lage eines dem Signal zugeordneten rotierenden Vektors angegeben wird, worin das Signal mit einer Frequenz 4F' abgetastet wird (wobei F' eine Frequenz des Frequenzbandes des Signals ist), worin ein angenäherter Wert $\hat{\Theta}'(t)$ für den Wert des den rotierenden Vektor angebenden Winkels (t) bestimmt wird, indem der Wert des Arkustangens des Verhältnisses $R = \frac{y'(t)}{x'(t)}$ eines Wertes x'(t) einer Abtastprobe des Signals zum Zeitpunkt t und eines Wertes y'(t) berechnet wird, welcher das arithmetische Mittel der Werte x'(t+1/4F') und x'(t−1/4F') ist, die der vorausgehenden Signalprobe x'(t) bzw. der darauffolgenden Probe x'(t) entsprechen, und worin der angenäherte Wert $\hat{\Delta}F$ der Frequenzvariation zwischen zwei Abtastzeitpunkten $t_1$, $t_2$, die um die Dauer 1/F' auseinanderliegen, bestimmt wird durch die Berechnung

$$\hat{\Delta}F = \frac{F'}{2\pi}[\hat{\Theta}'(t_2) - \hat{\Theta}'(t_1)].$$

2. Verfahren nach Anspruch 1, dadurch gekennzeichnet, dass der Fehler $\delta(\hat{\Delta}F)$, welcher bei der Bestimmung des angenäherten Wertes $\hat{\Delta}F$ für die Frequenzvariation gemacht wird, korrigiert wird, indem dieser angenäherte Wert $\hat{\Delta}F$ multipliziert wird mit einem Korrekturfaktor $(1-\varepsilon_n)$, dergestalt, dass

$$\varepsilon_n \cong \frac{\delta(\hat{\Delta}F)}{\hat{\Delta}F} \cong \frac{\varepsilon^2}{2} \times \cos(2\,\hat{\Theta}' + 4\,\varepsilon)\cdot$$

mit $\varepsilon = \frac{\delta F}{F'}$, und worin $\delta F$ der Frequenzhub um die Mittenfrequenz F ist.

3. Demodulator für ein frequenzmoduliertes Signal, in welchem das Verfahren nach Anspruch 1 angewendet wird, dadurch gekennzeichnet, dass er einen Abtaster (3) enthält, der das modulierte Signal mit einer Frequenz 4F' abtastet und einen Ausgang aufweist; einen Analog/Digital-Umsetzer (4) enthält, der einen mit dem Ausgang des Abtasters (3) verbundenen Eingang sowie einen Ausgang aufweist; eine erste Verzögerungsvorrichtung (5) enthält, deren Verzögerung gleich 1/4F' ist, mit einem an den Ausgang des Umsetzers (4) angekoppelten Eingang und einem Ausgang, der das Signal x'(t) zum Zeitpunkt t liefert; eine zweite Verzögerungsvorrichtung (6) enthält, deren Verzögerung gleich 1/4F' ist und die einen mit dem Ausgang der ersten Verzögerungsvorrichtung (5) verbundenen Eingang sowie einen Ausgang aufweist; eine Mitteilungsschaltung (7) enthält, welche das arithmetische Mittel ihrer Eingangssignale bildet, mit einem ersten, an den Ausgang des Umsetzers (4) angeschlossenen Eingang und einem zweiten, an den Ausgang der zweiten Verzögerungsvorrichtung (6) angeschlossenen Eingang sowie einem Ausgang, der das Signal y'(t) abgibt; eine Rechenvorrichtung (19) enthält, die nach der Formel:

$$⑪ \hat{\Theta}'(t) = \text{arc tg}\frac{y'(t)}{x'(t)}$$

den angenäherten Wert Ô '(t) des Winkelwertes Θ (t) berechnet, welcher der Lage des rotierenden Vektors zugeordnet ist, mit einem ersten, an den Ausgang der Mittelungsschaltung (7) angekoppelten Eingang und einem zweiten, an den Ausgang der ersten Verzögerungsvorrichtung (5) angekoppelten Eingang sowie einem Ausgang; ein Register (14) zur Speicherung jedes Winkelwertes Ô '(t) während einer Periode 1/F' umfasst, welches einen mit dem Ausgang der Rechenvorrichtung (19) verbundenen Eingang sowie einen Ausgang aufweist; eine Rechenschaltung (15) enthält, deren erster Eingang mit dem Ausgang der Rechenvorrichtung (19) und deren zweiter Eingang mit dem Ausgang des Registers (14) verbunden ist, während ihr Ausgang den angenäherten Wert $\hat{\Delta}$ F der Frequenzvariation gemäss der Formel ⑳ abgibt:

$$\hat{\Delta} F = \frac{F'}{2\pi}\left[\hat{\Theta}'(t+\frac{1}{F'}) - \hat{\Theta}'(t)\right]$$

4. Demodulator nach Anspruch 3, in dem das Verfahren nach Anspruch 2 zur Anwendung gelangt, dadurch gekennzeichnet, dass er einen Speicher (16) enthält, dessen erster Adressiereingang mit dem Ausgang der Rechenvorrichtung (19) und zweiter Adressiereingang mit dem Ausgang der Rechenschaltung (15) verbunden ist und welcher dauernd die Werte des Korrekturfaktors $(1-\varepsilon_n)$ speichert und ausgibt; und eine Multiplizierschaltung (17) enthält, deren erster Eingang mit dem Ausgang der Rechenschaltung (15) und deren zweiter Eingang mit dem Ausgang des Speichers (16) verbunden ist, während ihr Ausgang den korrigierten angenäherten Wert $\Delta F_1 = (1-\varepsilon_n)\cdot \Delta F$ der Frequenzvariation ausgibt.

5. Demodulator nach Anspruch 3, dadurch gekennzeichnet, dass die an den Ausgang des Abtasters (3) angekoppelten Vorrichtungen Ladungsverschiebevorrichtungen (CCD) sind und dass der Analog/Digital-Umsetzer entfällt.

## Claims

1. Method of demodulation of a signal which is frequency modulated about a central frequency F, having a bandwidth B such that $\frac{B}{2F} < 1$, wherein an approximate value $\hat{\Delta}$ F of a frequency variation of the signal is calculated by determination of the variation speed of the angle $\Theta$ (t) designating the position of a rotating vector associated with the signal, wherein the signal is sampled at a frequency 4F' (F' being a frequency of the frequency band of the signal), wherein an approximate value $\Theta$ '(t) of the value of the angle $\Theta$ (t) designating the rotating vector is determined by calculation of the value of the arc-tangent of the ratio

$R = \frac{y'(t)}{x'(t)}$, of a value x'(t) of a sample of the signal taken at the moment t, and of a value y'(t) which is the arithmetical mean of the values $x'(t + \frac{1}{4F'})$ and $x'(t - \frac{1}{4F'})$ corresponding to the preceding signal sample x'(t) and to the following sample x'(t), respectively; and wherein the approximate value $\hat{\Delta}$ F of the frequency variation between two sampling moments $t_1$, $t_2$ separated by a duration $\frac{1}{F'}$ is determined by calculating

$$\Delta = \frac{F'}{2\pi} [\hat{\Theta}'(t_2) - \hat{\Theta}'(t_1)].$$

2. Method according to claim 1, characterized in that the error $\delta(\hat{\Delta} F)$ which is made in the determination of the approximate value $\hat{\Delta}$ F of the frequency variation is corrected by multiplying this approximate value $\hat{\Delta}$ F by a correction factor $(1-\varepsilon_n)$ such that

$$\varepsilon_n \cong \frac{\delta(\hat{\Delta}F)}{\hat{\Delta}F} \simeq \frac{\varepsilon^2}{2} \times \cos(2\hat{\Theta}' + 4\varepsilon) \text{ avec}$$

with $\varepsilon = \frac{\delta F}{F'}$ and wherein $\delta F$ is the frequency excursion about the center frequency F.

3. Demodulator for a frequency modulated signal performing the method of claim 1, characterized in that it comprises a sampler (3) sampling the modulated signal at a frequency 4F', and having an output; an analog-digital converter (4) having an input coupled to the output of the sampler (3) and an output; a first delay device (5) having a delay of $\frac{1}{4F'}$ and having an input coupled to the output of the converter (4) and an output supplying the signal x'(t) at the moment t; a second delay device (6) having a delay equal to $\frac{1}{4F'}$, and having an input coupled to the ouptut of the first delay device (5) and an output; an averaging circuit (7) forming the arithmetical mean of its input signals and having first and second inputs coupled to the output of the converter (4) and to the output of the second delay device (6), respectively, and an output supplying the signal y'(t); a computing device (19) determining, in accordance with the formula:

⑪ $\hat{\Theta}'(t) = \text{arc tg } \frac{y'(t)}{x'(t)}$, the approximate value $\hat{\Theta}'(t)$ of the value of the angle $\Theta$ (t) associated with the position of the rotating vector, having first and second inputs coupled to the output of the averaging circuit (7) and to the output of the first delay device (5), respectively, and an output; a register (14) for storing each angle value $\hat{\Theta}'(t)$ during a period $\frac{1}{F'}$, and having an input coupled to the output of the computing device (19) as well as an output; a computing device (15) having first and second inputs coupled to the output of the computing device (19) and to the output of the register (14), respectively, and an output sup-

plying the approximate value $\hat{\Delta} F$ of the frequency variation in accordance with formula ⑫:

$$\hat{\Delta} F = \frac{F'}{2\pi}\left[\hat{\Theta}'(t+\frac{1}{F'}) - \hat{\Theta}'(t)\right]$$

4. Demodulator according to claim 3 performing the method according to claim 2, characterized in that it comprises a memory (16) having first and second addressing inputs coupled to the output of the computing device (19) and to the output of the computing circuit (15), respectively, and permanently storing and supplying the values of the correction factor $(1-\varepsilon_n)$; and a multiplying circuit (17) having a first input coupled to the output of the computing circuit (15), a second input coupled to the output of the memory (16) and an output supplying the approximate corrected value $\hat{\Delta} F_1 = (1-\varepsilon_n)\cdot\hat{\Delta} F$ of the frequency variation.

5. Demodulator according to claim 3, characterized in that the devices coupled to the output of the sampler (3) are charge transfer devices (C.C.D), and in that the analog-digital converter is dispensed with.